# DEMANDE DE BREVET EUROPEEN

(11) **EP 1 107 314 A1**
(43) Date de publication de la demande: **13.06.2001**
(21) Numéro de dépôt: 00410153.1
(22) Date de dépôt: 08.12.2000
(51) Int. Cl.: H01L 27/11, H01L 27/02

(54) **Transistors mos durcis**

(30) Priorité: 09.12.1999 FR 9915564
(71) Demandeur: STMicroelectronics SA, 94250 Gentilly Cedex (FR)
(72) Inventeur: Roche, Philippe, 38240 Meylan (FR)
(74) Mandataire: de Beaumont, Michel

(57) **Abrégé**

L'invention concerne un transistor MOS de type latéral comportant une grille (2) et des régions de drain (4) et de source (3) d'un premier type de conductivité formées dans un substrat (1) d'un deuxième type de conductivité relié à une première alimentation (GND), comprenant une couche enterrée (6) dopée du premier type de conductivité s'étendant sous ladite région de drain et sous une partie de la grille, la couche enterrée étant connectée à la grille par l'intermédiaire d'une liaison à conduction unidirectionnelle.

## Description

La présente invention concerne de façon générale les transistors de type à grille isolée (MOS). Plus particulièrement, la présente invention concerne la protection - ou durcissement - de tels transistors MOS vis-à-vis de particules ionisantes.

Sous l'effet de particules ionisantes, telles que, par exemple, des ions lourds, des protons, des particules alpha, on observe que des transistors MOS commandés pour être bloqués deviennent passants. On observe ceci plus particulièrement lors de l'impact de telles particules dans les zones de drain, identifiées comme étant les plus sensibles. Il en résulte des commutations inopportunes qui perturbent, voire endommagent, les dispositifs incorporant ces transistors. Par exemple, dans des dispositifs de mémoire statique à accès aléatoire (SRAM), de telles perturbations sont susceptibles de provoquer le changement de l'état logique mémorisé.

La réduction des dimensions caractéristiques des transistors accroît la sensibilité des transistors à de tels impacts.

Pour pallier les effets de telles perturbations, différentes techniques ont été proposées. On étudiera ci-après à titre non-limitatif diverses solutions proposées dans le cas particulier de mémoires de type SRAM.

Une première approche consiste à prévoir autour du dispositif un blindage, par exemple en aluminium, absorbant l'énergie des particules. Un tel blindage est encombrant et coûteux, d'autant qu'il doit être épais pour pouvoir absorber les particules les plus énergétiques.

Une deuxième approche consiste à modifier le circuit pour permettre à une cellule de retourner à son état initial après une perturbation. De telles modifications consistent, par exemple, à prévoir des cellules supplémentaires (redondance), ou à modifier la structure même des cellules SRAM élémentaires à six transistors pour garantir le verrouillage des données mémorisées. On a ainsi proposé des cellules à au moins dix transistors ou à découplage résistif. Toutefois, toutes ces modifications réduisent considérablement les performances des cellules, par exemple, en termes de temps d'accès et/ou de surconsommation. De plus, elles compliquent la réalisation sous forme monolithique de dispositifs mémoire et/ou augmentent leur encombrement d'où il résulte une densité mémoire réduite.

Une troisième approche consiste à modifier la technologie de fabrication des transistors MOS. On a ainsi utilisé des technologies de silicium sur isolant (SOI). Bien que les réductions des performances (temps d'accès, surconsommation, encombrement) observées soit alors plus faibles qu'avec les autres techniques déjà proposées, de telles technologies sont particulièrement complexes et coûteuses à mettre en oeuvre.

On a également proposé d'insensibiliser - "durcir" - les transistors individuels eux-mêmes. Toutefois, cela est effectué en surdimensionnant le transistor (augmentation de la zone de canal). Une telle solution est incompatible avec la volonté de réduction des dimensions des transistors. Une mémoire SRAM réalisée à partir de tels transistors serait lente et de faible densité.

Un objet de la présente invention est de proposer une nouvelle structure de transistors MOS qui présente un durcissement élevé aux particules ionisantes.

Un autre objet de la présente invention est de proposer une telle structure qui induise des contraintes (complexité, coût) de fabrication négligeables, ou à tout le moins nettement inférieures à celles induites par les solutions actuellement proposées.

Un autre objet de la présente invention est de proposer une structure de cellules mémoire de type SRAM durcie utilisant les transistors selon l'invention.

Un autre objet de la présente invention est de proposer une telle structure mémoire durcie qui présente un encombrement limité par rapport aux solutions existantes.

Un autre objet de la présente invention est de proposer une telle structure mémoire durcie qui présente des performances comparables à celles d'une mémoire classique.

Pour atteindre ces objets, la présente invention prévoit un transistor MOS de type latéral comportant une grille et des régions de drain et de source d'un premier type de conductivité formées dans un substrat d'un deuxième type de conductivité relié à une première alimentation, comprenant une couche enterrée dopée du premier type de conductivité s'étendant sous ladite région de drain et sous une partie de la grille, la couche enterrée étant connectée à la grille par l'intermédiaire d'une liaison à conduction unidirectionnelle.

Selon un mode de réalisation de la présente invention, le moyen à conduction unidirectionnelle est une diode dont la cathode est reliée à la grille du transistor et l'anode à la couche enterrée.

Selon un mode de réalisation de la présente invention, la liaison du substrat à la première alimentation est assurée par une région profonde fortement dopée du deuxième type de conductivité s'étendant jusqu'à une partie plus fortement dopée dudit substrat.

La présente invention prévoit également une cellule mémoire de type SRAM, dont deux premiers transistors à canal N de la cellule ont des structures selon le mode de réalisation précédent, et dont deux seconds transistors à canal P de la cellule sont réalisés dans un caisson de type N voisin de la zone dans laquelle sont formés les premiers transistors, les régions de drain des seconds transistors étant formées à proximité de ladite région fortement dopée des premiers transistors.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre, en vue en coupe partielle et schématique, une structure de transistor MOS selon la présente invention ;
la figure 2 est un schéma de circuit partiel illustrant une cellule mémoire SRAM élémentaire ;
la figure 3 illustre un mode de réalisation dans un même substrat de deux transistors MOS complémentaires selon la présente invention ; et
la figure 4 est une vue en perspective dans la cellule de la figure 2 réalisée selon un mode de réalisation de la présente invention.

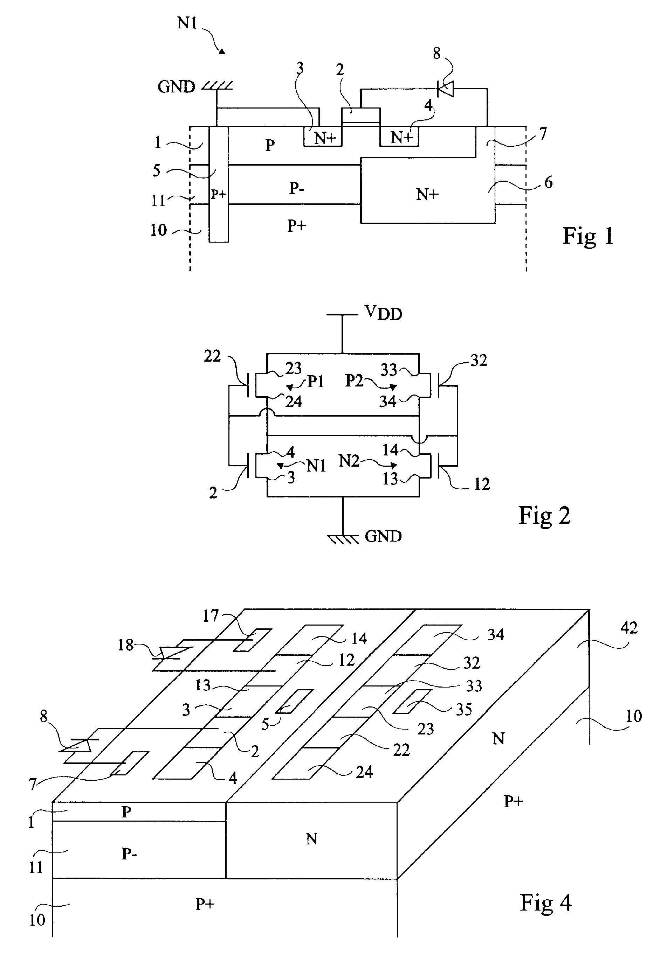

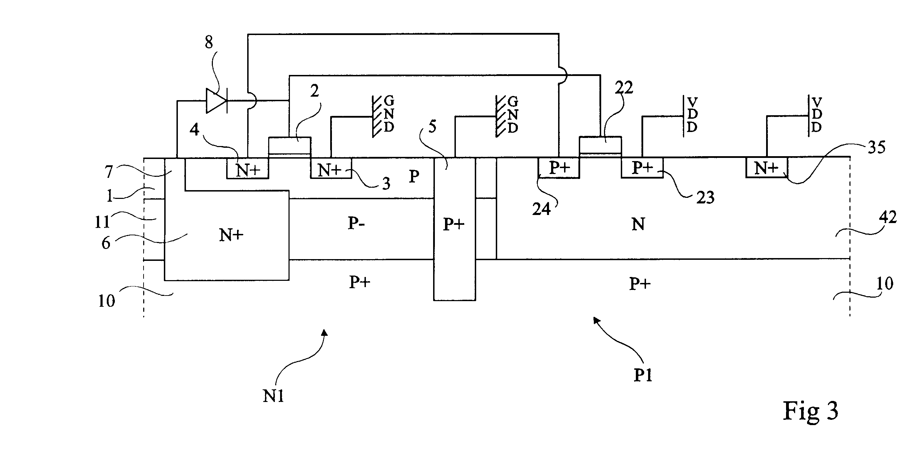

Par souci de clarté et comme cela est habituel dans la représentation des circuits intégrés, les vues en coupe des figures 1 et 3 ne sont pas tracées à l'échelle. De plus, de mêmes éléments ont été désignés par les mêmes références aux figures.

La figure 1 illustre, en vue en coupe partielle et schématique, un transistor MOS N1 à canal N réalisé selon les principes de la présente invention.

Le transistor N1 est formé dans une zone de surface 1 d'une couche épitaxiée 11 elle-même formée sur une tranche de silicium monocristallin 10. La zone 1, la couche 11 et la tranche 10 sont toutes trois dopées de type P, la tranche 10 étant la région la plus fortement dopée et la couche 11 la plus faiblement dopée. Une grille isolée 2, formée au-dessus de la zone 1, définit une zone de canal. De part et d'autre de la grille 2 se trouvent des régions de source 3 et de drain 4, fortement dopées de type N, formées dans la zone 1. Une région 5 fortement dopée de type P sert de contact substrat. La région de contact 5 et la source 3 sont reliées à un même potentiel de référence GND, par exemple, la masse du système.

Selon l'invention, la structure comprend également une couche enterrée 6 fortement dopée de type N. La couche 6 s'étend sous toute la région de drain 4 et sous une partie de la zone de canal. Elle n'atteint par contre pas la verticale de la région de source 3. La couche 6 et la grille 2 sont interconnectées au moyen d'une liaison à conduction unidirectionnelle. La liaison comporte par exemple un puits 7 de type N formé entre la couche 6 et la surface de la zone 1 et une diode 8 de type PN dont la cathode est reliée à la grille 2 et l'anode au puits 7. La diode 8 peut avantageusement être réalisée de façon monolithique de toute façon connue.

Le fonctionnement du transistor N1 est le suivant.

On considère tout d'abord le cas où la grille 2 du transistor N1 est polarisée, comme la source 3, au potentiel de référence GND du circuit alors que le drain 4 est connecté à une source d'alimentation haute Vdd. Le transistor est alors bloqué et la couche 6 n'affecte pas cet état.

Lors du bombardement de la zone de drain 4 par des particules ionisantes, des charges parasites apparaissent le long de leur trajectoire rectiligne dans la zone 1 et dans la tranche 10 sous le drain 4. Ces charges parasites sont récupérées par la couche 6 au lieu d'aller vers la source 3. La diode 8 devient passante et les charges parasites sont dérivées vers la grille 2 reliée à l'alimentation basse GND.

Dans le cas où la grille 2 et le drain 4 du transistor N1 sont polarisés à l'alimentation haute Vdd, la région 5 et la source 3 étant toujours polarisées au potentiel de référence GND, le transistor N1 est passant. Du fait de la présence de la diode 8, la couche enterrée 6 n'affecte pas le fonctionnement du transistor N1. En effet, la couche 6 est au même potentiel de masse GND, à une chute de tension près de jonction, que la couche épitaxiée 11 environnante. Pour améliorer cette polarisation au potentiel de référence, par exemple, de valeur nulle, on prévoit une région conductrice 5 profonde traversant la région 1 et la couche épitaxiée 11 et atteignant la tranche de silicium sous-jacente 10 plus fortement dopée.

La position de la couche 6 devra être choisie de façon à ne pas perturber la répartition des équipotentielles sous la grille et autour de la jonction drain-substrat. Par contre, il faut que la couche 6 soit suffisamment proche du drain 4 pour que les charges créées par le passage d'une particule ionisante dans la structure soient absorbées.

On notera qu'il faut également que le dopage de la couche 6 soit élevé, notamment pour que la couche 6 soit suffisamment conductrice pour transférer rapidement les charges parasites vers la masse.

Les éléments supplémentaires (couche enterrée 6, puits 7, diode 8) à introduire dans une structure classique pour obtenir une structure selon l'invention décrite précédemment sont avantageusement simples et peu coûteux à réaliser et n'entraînant pratiquement pas d'augmentation de surface du composant.

L'homme de l'art comprendra que les principes de l'invention décrits et illustrés précédemment appliqués à la formation d'un transistor MOS à canal N dans une technologie sur substrat P s'appliquent également à un transistor MOS à canal P dans une technologie sur substrat N à condition de doper de façon complémentaire les différentes zones, régions et couches ainsi que la tranche de silicium.

La présente invention s'applique tout particulièrement à la réalisation dans un même substrat de transistors complémentaires, par exemple pour réaliser des cellules mémoire de type SRAM.

La figure 2 est un schéma électrique d'une cellule mémoire de type SRAM. Cette cellule comporte quatre transistors, à savoir deux transistors N1 et N2 à canal N et deux transistors P1 et P2 à canal P. Les transistors N1 et N2 sont interconnectés par leurs sources respectives 3 et 13 à une même alimentation basse GND. Les transistors P1 et P2 sont interconnectés par leurs sources respectives 23 et 33 à une même alimentation haute Vdd. Les transistors N1, N2, P1 et P2, sont associés en deux paires complémentaires N1-P1 et N2-P2 de la façon suivante. Les drains 4-24, 14-34 et les grilles 2-22, 12-32 des deux transistors d'une même paire N1-P1, N2-P2 sont interconnectés. Le point milieu des interconnexions de drain 4-24, 14-34 d'une paire N1-P1, N2-P2 est relié au point commun de grille 12-32, 2-22 de l'autre paire N2-P2, N1-P1.

Les transistors à canal N de cette cellule, qui sont les plus sensibles à des particules ionisantes peuvent avantageusement être réalisés selon l'invention.

La figure 3 illustre un mode de réalisation selon la présente invention de deux transistors complémentaires, correspondant aux transistors NI et P1 de la figure 2 formés dans une même puce semiconductrice.

La partie gauche de la figure 3 représente le transistor N1 de la figure 1 formé dans une zone de surface 1 d'une couche épitaxiée 11 plus faiblement dopée de type P que la tranche 10 sous-jacente. La zone 1 est plus fortement dopée que la couche 11. Le transistor N1 comporte comme précédemment une grille 2, des régions de source 3 et de drain 4, une région 5 de contact de substrat, une couche enterrée 6 et une liaison à conduction unidirectionnelle entre la couche 6 et la grille 2. On suppose comme précédemment que la source 3 et la région 5 sont polarisées au potentiel de référence GND du circuit.

La même tranche 10 comporte également, à droite de la figure, un transistor P1 à canal P. Celui-ci est formé dans un caisson 42 de type N. Le transistor P1 comprend des régions fortement dopées de type P, constituant respectivement sa source 23 et son drain 24, formées à la surface du caisson 42 de part et d'autre d'une zone de canal définie par une grille isolée 22. Une région 35 fortement dopée de type N formée à la surface du caisson 42 assure le contact substrat du transistor P1. La source 23 et la région 35 sont polarisées par l'alimentation haute Vdd.

Enfin, la figure 3 illustre la connexion du drain 4 et de la grille 2 du transistor N1 respectivement au drain 24 et à la grille 22 du transistor P1, conformément à la structure de la figure 2. De telles connexions sont réalisées à l'aide de tout procédé usuel de formation de telles liaisons conductrices.

On notera que, si le caisson de type N 42 est peu profond, du fait de la polarisation à la masse des régions P sous-jacentes (tranche 10) par la région profonde 35, ces régions P sous-jacentes jouent pour le transistor P1 à canal P un rôle similaire à celui de la région 6 pour le transistor N1 à canal N. Pour améliorer l'évacuation des charges parasites par la portion de région P située sous le drain 24 du transistor P1, la région profonde de polarisation 5 sera de préférence, comme cela est représenté, proche en vue de dessus de la région de drain 24.

La figure 4 est une vue en perspective schématique d'un mode de réalisation de la cellule SRAM de la figure 2 dans une tranche semiconductrice 10 fortement dopée de type P, selon les principes exposés à la figure 3. Les transistors N1, N2 à canal N sont formés dans une zone 1 d'une couche épitaxiée 11 dopée de type P. Les transistors P1, P2 à canal P sont formés dans un caisson de type N 42 formé à la surface de la tranche 10. Les transistors d'un même type sont alignés de façon à avoir une région de source commune. En vue de dessus, on voit donc une succession drain - grille - source - grille - drain. Une couche enterrée fortement dopée de type N (non représentée) se trouve sous chaque région de drain 4, 14 des transistors N1, N2. Chaque couche enterrée est reliée à la grille 2, 12 du transistor par l'intermédiaire d'un puits 7, 17 et d'une diode 8, 18. La cathode de la diode 8, 18 est connectée à la grille 2, 12 alors que son anode est reliée au puits 7, 17. On forme également des régions de contact substrat 5 et 35 respectivement dans la zone 1 et dans le caisson 42. La région 35 est une région de surface peu profonde alors que la région 5 traverse la zone 1 et la couche 11 et atteint la tranche 10 fortement dopée de type P. La région 5 est formée de préférence à proximité de la limite entre la zone 1 et le caisson 42, pour assurer la polarisation de la tranche 10 au potentiel de référence en deçà des régions de drain 24-34 des transistors P1, P2, comme cela a été exposé précédemment en relation avec la figure 3.

La cellule mémoire décrite précédemment (figure 2), réalisée selon les principes de l'invention exposés en relation avec les figures 1 et 3, présente avantageusement un durcissement élevé. Il faudra en effet des particules ionisantes présentant un transfert d'énergie par unité de longueur (Linear Energy Transfer) de plus de sensiblement 120 MeV.cm²/mg pour provoquer des citations intempestives de la cellule, ce qui est au-delà des normes de durcissement courantes.

Ce durcissement élevé est acquis au prix de réductions de performances et de densité de la mémoire négligeables devant celles d'une mémoire selon les techniques antérieures.

En effet, l'encombrement supplémentaire introduit par la formation des deux couches enterrées, des deux puits 7, 17 et des deux diodes 8, 18 est inférieur à celui des solutions à redondance ou à cellule à au moins dix transistors. De plus, comparées à ces solutions existantes, les jonctions supplémentaires formées introduisent des capacités parasites négligeables devant celles liées à la formation de structures de grille supplémentaires.

Comparée à une solution à découplage résistif, une structure selon l'invention est également avantageuse. En effet, comme cela a été exposé en relation avec la figure 2, en l'absence de perturbations, le fonctionnement des transistors n'est pas modifié et aucune résistance supplémentaire n'est introduite. En présence de particules ionisantes bombardant une région de drain d'un transistor à canal N, la surconsommation introduite par la résistance de la couche 6 est négligeable devant celle provoquée par les résistances élevées nécessaires au découplage résistif.

Bien entendu, la présente invention est susceptible de diverses variantes et modifications qui apparaîtront à l'homme de l'art. En particulier, on a décrit et illustré précédemment les principes de l'invention appliqués à la formation d'une cellule mémoire du type SRAM dans un substrat de type P. Toutefois, on pourrait former selon les mêmes principes une telle cellule dans un substrat de type N à condition de doper de façon complémentaire les différents caissons, couches ou régions en silicium. En outre, l'homme de l'art comprendra que l'on pourrait appliquer un tel procédé de durcissement à la formation d'autres types de dispositifs.

De même, bien qu'on a choisi d'assurer la polarisation du substrat et de la source d'un transistor donné par une connexion à une même alimentation haute (Vdd) ou basse (GND), l'homme de l'art saura les polariser le cas échéant à des niveaux différents, par exemple dans le cas de commutateurs haute fréquence.

L'homme de l'art saura également adapter les matériaux décrits à une filière de fabrication spécifique et sélectionner les niveaux de dopage des diverses couches semiconductrices en fonction des performances recherchées.

## Revendications

1. Transistor MOS de type latéral comportant une grille (2) et des régions de drain (4) et de source (3) d'un premier type de conductivité formées dans un substrat (1) d'un deuxième type de conductivité relié à une première alimentation (GND), caractérisé en ce qu'il comprend une couche enterrée (6) dopée du premier type de conductivité s'étendant sous ladite région de drain et sous une partie de la grille, la couche enterrée étant connectée à la grille par l'intermédiaire d'une liaison à conduction unidirectionnelle.

2. Transistor selon la revendication 1, caractérisé en ce que le moyen à conduction unidirectionnelle est une diode (8) dont la cathode est reliée à la grille (2) du transistor et l'anode à la couche enterrée (6).

3. Transistor selon la revendication 1 ou 2, caractérisé en ce que la liaison du substrat (1) à la première alimentation (GND) est assurée par une région profonde (5) fortement dopée du deuxième type de conductivité s'étendant jusqu'à une partie (10) plus fortement dopée dudit substrat.

4. Cellule mémoire de type SRAM, caractérisée en ce que deux premiers transistors (N1, N2) à canal N de la cellule ont des structures selon la revendication 3, et en ce que deux seconds transistors (P1, P2) à canal P de la cellule sont réalisés dans un caisson de type N (42) voisin de la zone dans laquelle sont formés les premiers transistors, ladite région fortement dopée (5) des premiers transistors étant formée à proximité de la limite entre le caisson et la zone.
